# EUROPÄISCHE PATENTSCHRIFT

(11) **EP 4 009 527 B1**
(45) Veröffentlichungstag und Bekanntmachung des Hinweises auf die Patenterteilung: **04.03.2026**
(21) Anmeldenummer: 21209808.1
(22) Anmeldetag: 23.11.2021
(51) Int. Cl.: H03K 17/96, F24C 7/08

(54) **BEDIENEINHEIT FÜR EIN HAUSHALTSGERÄT**
OPERATIONAL UNIT FOR A DOMESTIC APPLIANCE
UNITÉ DE COMMANDE POUR UN APPAREIL ÉLECTROMÉNAGER

(30) Priorität: 02.12.2020 DE 102020215166
(43) Veröffentlichungstag der Anmeldung: 08.06.2022
(73) Patentinhaber: BSH Hausgeräte GmbH, 81739 München (DE)
(72) Erfinder: Schlaß, Alexander, 14624 Dallgow-Döberitz (DE); Srokos, Julia, 16321 Bernau (DE); Stadler, Dominik, 93128 Regenstauf (DE); Zei, Carsten, 93161 Sinzing (DE)

(56) Entgegenhaltungen:
- EP-A1- 1 903 284
- WO-A1-2015/090361
- DE-A1- 102015 013 054
- DE-A1- 102016 212 995
- DE-A1- 102019 104 435
- DE-U1- 202014 101 897
- US-A1- 2010 142 211

## Beschreibung

Die Erfindung betrifft eine Bedieneinheit für ein Haushaltsgerät mit einer berührungssensitiven Einheit und einer rückseitig zu dieser positionierten LED-Einheit, wobei die berührungssensitive Einheit mit einer Diffusorfolie gebildet ist, deren einem Bediener zugewandte Oberseite mindestens eine Zeichenschicht und deren hiervon abgewandte Unterseite mindestens eine Funktionsschicht aufweist.

Aus dem Stand der Technik sind eine Vielzahl von Bedieneinheiten für Haushaltsgeräte bekannt. Im einfachsten Fall erfolgt die Bedienung eines Haushaltsgeräts mit Hilfe von Druckknöpfen oder Drehschaltern, deren Position mit Hilfe von Markierungen auf einer Blende sichtbar ist. Weiterhin ist der Einsatz von unbeleuchteten Folientasten zum Beispiel auf Mikrowellen bekannt. Weiterhin sind um ein kleines LCD-Display herum gruppierte, berührungsempfindliche Sensortasten bekannt, deren jeweils aktuelle Funktion einem Benutzer mit einem Symbol angezeigt wird.

Darüber hinaus sind inzwischen verbreitet auch berührungssensitive Bildschirme mit einer Hintergrundbeleuchtung, so genannte "Touchscreens", in Haushaltsgeräten im Einsatz, die ein besonders komfortables Bedienerlebnis für den Anwender ermöglichen. Zudem lassen sich Touchscreens aufgrund der durchgehenden, glatten Oberfläche besonders leicht reinigen und sind im Vergleich zu konventionellen Bedienelementen hygienischer. Von Nachteil ist, dass sich die Bediensymbole für hintergrundbeleuchtete Touchscreens in der Serienfertigung nur mit einem vergleichsweise hohen Aufwand an andere Anforderungen bzw. Gerätevariationen anpassen lassen.

Die WO 2015/090361 A1 offenbart den Oberbegriff des Anspruchs 1. Die US 2010/142211 A1, DE 10 2015 013054 A1, DE 20 2014 101897 U1, EP 1 903 284 A1, DE 10 2019 104435 A1 und DE 10 2016 212995 A1 sind weitere relevante Teile des Stands der Technik.

Eine Aufgabe der Erfindung ist es daher, eine berührungssensitive und hintergrundbeleuchtete Bedieneinheit anzugeben, deren Symbolik eine große und zudem leicht zu ändernde Variabilität aufweist.

Die eingangs genannte Aufgabe wird nach Maßgabe des Patentanspruchs 1 dadurch gelöst, dass die mindestens eine Zeichenschicht mindestens ein mittels Laserstrahlung hergestelltes Zeichen aufweist, das für Licht der LED-Einheit zumindest teilweise durchlässig ist, wobei die Zeichenschicht außerhalb des mindestens einen Zeichens für Licht der LED-Einheit undurchlässig ist.

Infolgedessen sind die Zeichen innerhalb der Zeichenschicht vollkommen unabhängig und daher nach dem Abschluss des Herstellungsprozesses der berührungssensitiven Einheit und der zugeordneten Beleuchtungseinheit sowie der Verbindung zu der kompletten Bedieneinheit herstellbar. Hierdurch lässt sich eine große Modellvielfalt von Bedieneinheiten für unterschiedliche Typen von Haushaltsgeräten mit geringem Aufwand realisieren. Die Zeichen können beispielsweise in einem Abtragverfahren mittels Laserstrahlung einer vorab auf die Diffusorfolie aufgebrachten, lichtundurchlässigen Schicht, Beschichtung, Folie oder dergleichen realisiert werden. Darüber hinaus ist eine tiefgehende Lasergravur der lichtundurchlässigen Schicht oder das Herausschneiden der gewünschten Zeichenkontur mittels Laserstrahlung aus der lichtundurchlässigen Schicht möglich. Die Herstellung der mindestens einen Funktionsschicht, die die Leiterbahnen, die kapazitiven Tastelektroden sowie ein elektrisches Interface enthält, kann zum Beispiel durch Herausschneiden einer entsprechenden Leiterbahnführung aus einer aufkaschierten Kupferfolie mit Hilfe von Laserstrahlung geeigneter Wellenlänge und Intensität bzw. Leistung erfolgen. Die Funktionsschicht mit der für die Touchfunktionalität notwendigen Leiterbahnführung kann im Wege eines konventionellen Siebdruckverfahrens ausgebildet werden. Die Funktionsschicht ist vorzugsweise auf die benutzerabgewandte Seite der Diffusorfolie aufgedruckt. Die Funktionsschicht kann alternativ auch mit einer als eine separate Komponente ausgeführten, berührungssensitiven Folie realisiert sein. Diese berührungssensitive Folie kann auf geeignete Art und Weise mit der benutzerabgewandten Seite der Diffusorfolie verbunden, beispielsweise verklebt oder verschweißt, sein. Darüber hinaus erlaubt das Herstellen der Zeichen innerhalb der Zeichenschicht mittels Laserstrahlung eine besonders hohe Konturschärfe und Maßhaltigkeit der Zeichen bei zugleich praktisch beliebiger Variabilität. Die Laserstrahlung kann mit einem Gas- oder Festkörperlaser mit hinreichend hoher Leistung bei einer zum Schneiden und zur Tiefengravur geeigneten Wellenlänge generiert werden. Der Begriff "LED" (so genannte "Light Emitting Diode") wird im Kontext der vorliegenden Beschreibung synonym für "Leuchtdiode" verwendet.

Erfindungsgemäß weist eine Leiterplatte der LED-Einheit mindestens eine Leuchtdiode zur bevorzugt selektiven Hinterleuchtung mindestens eines zugeordneten Zeichens der Zeichenschicht auf. Aufgrund der Hinterleuchtung der Zeichen der Zeichenschicht ist eine besonders gute Ablesbarkeit gegeben. Erforderlichenfalls können durch das Aktivieren bestimmter LEDs der LED-Einheit die jeweils zugeordneten Zeichen selektiv zum Aufleuchten oder periodischen Aufblinken gebracht werden, um beispielsweise gezielte Bedienungshinweise an einen Bediener des Haushaltsgeräts zu übermitteln.

Erfindungsgemäß weist die Leiterplatte der LED-Einheit mindestens eine numerische und/oder alphanumerische Anzeige zur bevorzugt selektiven Hinterleuchtung eines zugeordneten Zeichens der Zeichenschicht auf. Hierdurch ist eine umfangreichere Bedienerinteraktion realisierbar. Die mindestens eine Anzeige kann zum Beispiel in der Form einer LED 7-Segmentanzeige, einer LED 5 x 7-Punktmatrixanzeige etc. ausgeführt sein.

Erfindungsgemäß weist die mindestens eine Funktionsschicht eine Vielzahl von kapazitiven Tastelektroden auf, die dazu ausgebildet sind, im Fall einer räumlichen Annäherung eines Bedienerfingers jeweils ein auswertbares elektrisches Signal zu generieren, das mittels eines ersten elektrischen Interfaces der mindestens einen Funktionsschicht ableitbar ist. Infolgedessen ist eine kontaktlose, mechanisch robuste und zugleich intuitive Ansteuerung der Funktionen des Haushaltsgeräts mittels der Bedieneinheit gewährleistet. Darüber hinaus ist die Bedieneinheit unempfindlich gegen Feuchtigkeit und leicht durch Abwischen zu reinigen, sodass ein hoher Hygienestandard der Bedieneinheit sichergestellt ist.

Im Fall einer weiteren Ausgestaltung weist die Leiterplatte der LED-Einheit ein zweites elektrisches Interface auf, das mit dem ersten elektrischen Interface der berührungssensitiven Einheit und/oder mit mindestens einer der Leiterplatte zugeordneten elektronischen Steuereinheit und/oder einer elektronischen Steuer- und/oder Regeleinheit des Haushaltsgeräts verbunden ist. Hierdurch ist eine problemlose elektrische Integration der Bedieneinheit in das Haushaltsgerät gegeben.

Vorzugsweise ist die elektronische Steuereinheit zumindest dazu ausgebildet, die elektrischen Signale der kapazitiven Tastelektroden auszuwerten. Infolgedessen lassen sich die vergleichsweise schwachen kapazitiven Signale der Tastelektroden verstärken und die mit den Tastelektroden ausgebildeten berührungssensitiven Tasten zuverlässig auswählen.

Erfindungsgemäß ist die mindestens eine Funktionsschicht unterseitig mit einer Schutzschicht versehen, die ihrerseits unterseitig zumindest bereichsweise mit einer Klebeschicht versehen ist. Aufgrund der Klebeschicht ist eine robuste sowie leicht herzustellende mechanische Verbindung zwischen der berührungssensitiven Einheit und der LED-Einheit zur Schaffung der Bedieneinheit gegeben.

Erfindungsgemäß ist vorgesehen, dass die Klebeschicht unterseitig eine nicht adhäsive Abziehschicht aufweist.

Hierdurch ist eine leichtere Handhabung der berührungssensitiven Einheit bis zur Endmontage der Bedieneinheit gegeben.

Erfindungsgemäß ist jeder Leuchtdiode und jeder numerischen oder alphanumerischen Anzeige der LED-Einheit ein Lichtschacht als Teil einer Lichtführung zugeordnet. Hierdurch wird ein optisches Übersprechen von Lichtsignalen räumlich dicht benachbarter Leuchtdioden oder alphanumerischer LED-Displays vermieden (so genanntes "Cross-Talking"), wodurch eine besonders konturscharfe Hinterleuchtung der Zeichen der Zeichenschicht möglich ist. Die Lichtschächte können eine zumindest bereichsweise verspiegelte Innenfläche aufweisen.

Erfindungsgemäß weist die Lichtführung außerhalb der Lichtschächte eine der berührungssensitiven Einheit zugewandte lichtundurchlässige Blockierschicht auf. Infolgedessen werden Lichtreflektionen vermieden, die ansonsten zwischen Grenzschichten im Stapelaufbau auftreten. Die Blockierschicht ist oberseitig auf die Lichtführung unter jeweils maskenartiger Aussparung bzw. Auslassung der Lichtschächte angeordnet und kann beispielsweise mit einer aufgeklebten, dünnen schwarzen Folie gebildet sein.

Bei einer vorteilhaften technischen Weiterbildung ist vorgesehen, dass die Zeichenschicht eine lichtdurchlässige Abdeckung aufweist. Hierdurch wird eine Beschädigung der Zeichenschicht durch äußere mechanische Einwirkungen im Betrieb des Haushaltsgeräts vermieden.

Bevorzugt weist die berührungssensitive Einheit einen 2D-Sensor unter Schaffung eines berührungssensitiven Bereichs auf, derart, dass das mindestens eine Zeichen der Zeichenschicht weitgehend frei innerhalb des berührungssensitiven Bereichs ausbildbar ist. Hierdurch sind eine besonders hohe Flexibilität hinsichtlich der zweidimensionalen Positionierbarkeit der Zeichen der Zeichenschicht und der diesen jeweils zugeordneten Funktionalitäten gegeben. Die mindestens eine Funktionsschicht kann zu diesem Zweck eine Vielzahl von kapazitiv wirkenden Tastelektroden aufweisen, die beispielsweise in der Form eines regelmäßigen, hinreichend feinen orthogonalen und zweidimensionalen Punktrasters angeordnet sein können.

Im Folgenden wird ein bevorzugtes Ausführungsbeispiel der Erfindung anhand von schematischen Figuren näher erläutert. Es zeigen
- Figur 1: einen stark schematisierten Querschnitt einer erfindungsgemäßen Bedieneinheit in einem teilmontierten Zustand,
- Figur 2: eine Draufsicht auf die Bedieneinheit von Figur 1 für ein Haushaltsgerät,
- Figur 3: eine schematische, perspektivische Ansicht der berührungssensitiven Einheit der Bedieneinheit gemäß der Figuren 1, 2, und
- Figur 4: die berührungssensitive Einheit von Fig. 3 mit einem beispielhaften, mittels Laserstrahlung eines geeigneten Lasers ausgebildeten Zeichen.

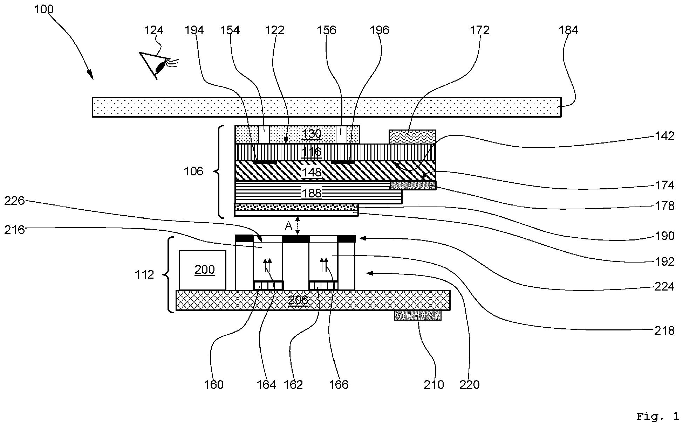

Die Figur 1 zeigt einen stark schematisierten Querschnitt einer erfindungsgemäßen Bedieneinheit in einem teilmontierten Zustand.

Die Bedieneinheit 100 für ein nicht dargestelltes Haushaltsgerät umfasst unter anderem eine berührungssensitive Einheit 106 und eine rückseitig zu dieser positionierte LED-Einheit 112. Die berührungssensitive Einheit 106 ist mit einer Diffusorfolie 116 gebildet und dient zur Vergleichmäßigung der Hinterleuchtung durch die LED-Einheit 112. Eine Oberseite 122 der Diffusorfolie 116 weist mindestens eine, einem Auge 124 eines nicht eingezeichneten menschlichen Bedieners des Haushaltsgeräts zugewandte, zumindest bereichsweise ausgebildete Zeichenschicht 130 auf. An einer bedienerabgewandten Unterseite 142 der Diffusorfolie 116 ist eine elektrische Funktionsschicht 148 ausgebildet. Die mindestens eine Zeichenschicht 130 weist hier lediglich exemplarisch zwei mittels hier nicht eingezeichneter Laserstrahlung erzeugte Zeichen 154, 156 auf. Die Zeichen 154, 156 der Zeichenschicht 130 sind jeweils für, von hier lediglich exemplarisch zwei Leuchtdioden 160, 162 der LED-Einheit 112 abgestrahltes, sichtbares Licht 164, 166 zumindest teilweise durchlässig. Bevorzugt durchsetzen die Zeichen 154, 156 die Zeichenschicht 130 vollständig. Die Zeichenschicht 130 ist außerhalb der Zeichen 154, 156 im Wesentlichen lichtundurchlässig nach Art einer Maske bzw. Maskierung ausgeführt. Die Zeichen 154, 156 können beispielsweise mittels Abtrag durch Laserstrahlung einer vorab auf die Diffusorfolie als Zeichenschicht 130 aufgebrachten, lichtundurchlässigen Schicht oder Folie realisiert werden. Darüber hinaus ist eine tiefgehende Lasergravur der als Zeichenschicht 130 dienenden, lichtundurchlässigen Schicht oder das vollständige Herausschneiden der Zeichenkontur mit Hilfe von Laserstrahlung ausreichend hoher Intensität aus der Zeichenschicht 130 möglich.

Die Diffusorfolie 116 verfügt bevorzugt im Bereich ihrer Oberseite 122 über eine bereichsweise ausgeführte Versteifung 172. Vorzugsweise im Bereich einer Unterseite 174 der Funktionsschicht 148 ist ein erstes elektrisches Interface 178 ausgebildet. Die Versteifung 172 ist vom elektrischen Interface 178 durch die Diffusorfolie 116 sowie die Funktionsschicht 148 vertikal getrennt, diese sind jedoch im Wesentlichen kongruent zueinander positioniert, um eine möglichst zuverlässige, elektrisch und mechanisch robuste Kontaktierung der berührungssensitiven Einheit 106 zu gewährleisten. Die Zeichenschicht 130 sowie die Versteifung 172 sind bevorzugt oberseitig vollflächig mit einer lichtdurchlässigen Abdeckung 184 versehen, sodass eine mechanische Beschädigung der Zeichenschicht 130 ausgeschlossen ist. Die Abdeckung 184 kann selektiv durchlässig für das von den Leuchtdioden 160, 162 emittierte Licht 164, 166 ausgeführt sein, um den Einfluss von Umgebungslicht zu verringern.

Die Unterseite 174 der Funktionsschicht 148 ist vorzugsweise bis auf das erste elektrische Interface 178 mit einer Schutzschicht 188 vor schädlichen, insbesondere korrosiven Umwelteinflüssen sowie Feuchtigkeit geschützt. Die Schutzschicht 188 ist zumindest teilweise mit einer Klebeschicht 190 versehen, die ihrerseits zur Erleichterung der Handhabung der berührungssensitiven Einheit 106 vor deren endgültiger Verbindung mit der LED-Einheit 112 mit einer nicht adhäsiven folienartigen Abziehschicht 192 zumindest bereichsweise bedeckt ist. Sowohl die Funktionsschicht 148 als auch die Schutzschicht 188 und die Klebeschicht 190 sind für das von den Leuchtdioden 160, 162 emittierte Licht 164, 166 hinreichend durchlässig.

Die Funktionsschicht 148 weist hier lediglich beispielhaft zwei kapazitiv wirkende Tastelektroden 194, 196 auf, die dazu ausgebildet sind, bei einer Annäherung eines Fingers des menschlichen Bedieners jeweils ein elektrisches Signal zu erzeugen, das mittels des ersten elektrischen Interfaces 178 der Funktionsschicht 148 zur Weiterverarbeitung ableitbar ist.

Die Weiterverarbeitung der von den kapazitiven Tastelektroden 194, 196 generierten elektrischen Signale kann beispielsweise mithilfe einer, der LED-Einheit 112 zugeordneten elektronischen Steuereinheit 200 erfolgen. Die kapazitiven Tastelektroden 194, 196 der Funktionsschicht 148 sowie nicht dargestellte elektrische Leiterbahnen zu deren elektrischer Verbindung mit dem ersten elektrischen Interface 178 können beispielsweise mit Hilfe eines Siebdruckverfahrens ausgebildet werden. Alternativ oder ergänzend kann die Funktionsschicht 148 zumindest bereichsweise mit einer nicht dargestellten Kupferfolie kaschiert sein, in der die kapazitiven Tastelektroden 194, 196, die Leiterbahnen sowie das erste elektrische Interface 178 zum Beispiel durch chemische Ätzverfahren und/oder mittels Freischneiden durch Laserstrahlung ausgebildet sind.

Die LED-Einheit 112 verfügt hier nur beispielhaft über eine Leiterplatte 206 bzw. ein PCB (so genanntes "Printed Circuit Board"). Die Leiterplatte 206 dient unter anderem zur elektrischen Verschaltung der Leuchtdioden 160, 162, der elektronischen Steuereinheit 200 und eines zweiten elektrischen Interfaces 210 mithilfe nicht eingezeichneter elektrischer Leiterbahnen. Die Leiterplatte 206 kann ferner nicht dargestellte numerische und/oder alphanumerische Anzeigen aufweisen, um eine komplexere Interaktion mit dem Bediener zu ermöglichen. Eine numerische Anzeige kann beispielsweise mittels einer LED 7-Segment-Anzeige und eine alphanumerische Anzeige kann mit einer LED 5 x 7 Punktmatrix-Anzeige realisiert sein. Weiterhin können zur eingeschränkt alphanumerischen Darstellung so genannte LED 17-Segment-Anzeigen zum Einsatz kommen. Die Leuchtdioden 160, 162 sind jeweils bevorzugt direkt unterhalb der ihnen zugeordneten Zeichen 154, 156 der Zeichenschicht 130 positioniert, sodass die Zeichen 154, 156 erforderlichenfalls auch individuell beleuchtbar sind. Dasselbe gilt für optional vorgesehene alphanumerische Anzeigen bzw. Displays der LED-Einheit 112.

Das zweite elektrische Interface 210 der Leiterplatte 206 der LED-Einheit 112 kann beispielsweise mit dem ersten elektrischen Interface 178 der berührungssensitiven Einheit 106 und/oder mit der elektronischen Steuereinheit 200 und/oder mit einer nicht dargestellten übergeordneten elektronischen Steuer- und/oder Regeleinheit des Haushaltsgeräts elektrisch leitend verbunden sein.

Jeder der Leuchtdioden 160, 162 ist hier ein Lichtschacht 216, 218 zugeordnet, um ein optisches Übersprechen der Leuchtdioden 160, 162 (so genanntes "Cross Talking") zu vermeiden. Hierdurch wird beim Beleuchten des ersten Zeichens 154 durch das Aktiveren der Leuchtdiode 160 das zweite Zeichen 156 bei inaktiver Leuchtdiode 162 nicht passiv mit ausgeleuchtet. Entsprechendes gilt für die optional vorgesehene alphanumerische LED-Anzeige der LED-Einheit 112. Die beiden tubusartigen Lichtschächte 216, 218 bilden in ihrer Gesamtheit eine Lichtführung 220 der LED-Einheit 112 aus. Darüber hinaus ist die Lichtführung 220 außerhalb der Lichtschächte 216, 218 mit einer lichtundurchlässigen bzw. lichtabsorbierenden Blockierschicht 224 bedeckt, um unerwünschte Lichtreflexionen zu vermeiden. Zu diesem Zweck ist die Blockierschicht 224 auf einer Oberseite 226 der Lichtführung unter jeweils maskenartiger Aussparung bzw. Freilassung der Lichtschächte 216, 218 befestigt, insbesondere aufgeklebt oder verschweißt. Zwischen der berührungssensitiven Einheit 106 und der LED-Einheit 112 besteht in dem hier illustrierten teilmontierten Zustand der Bedieneinheit 100 noch ein geringer Abstand A. Zur Komplettierung der Montage der Bedieneinheit 100 wird die Abziehschicht 192 entfernt und die berührungssensitive Einheit 106 mithilfe der Klebeschicht 190 mit der Blockierschicht 224 der LED-Einheit 112 durch Verkleben, Verschweißen etc. zusammengefügt, sodass der Abstand A null wird.

Durch das individuelle Ansprechen bzw. Einschalten der Leuchtdioden 160, 162 mit Hilfe der elektronischen Steuereinheit 200 können die jeweils zugeordneten Zeichen 154, 156 beispielsweise dauerhaft oder periodisch blinkend zum Aufleuchten gebracht werden. Hierdurch kann zum Beispiel ein vom aktuellen Status des Haushaltsgeräts abhängiger, intuitiv wahrnehmbarer Bedienhinweis an den Bediener gegeben werden, die dem blinkenden Zeichen 154, 156 zugewiesene Tastelektroden 194, 196 zu betätigen.

Beispielsweise kann der Bediener im Fall einer Waschmaschine aktiv durch entsprechendes Aktiveren der hinterleuchteten Zeichen 154, 156 dazu aufgefordert werden, ein geeignetes Waschprogramm, eine Waschtemperatur und/oder eine Schleuderdrehzahl vorzuwählen und die Waschmaschine zu starten. Darüber hinaus kann beispielsweise ein Warnhinweis gegeben werden, den Wasseranschluss der Waschmaschine freizugeben, um den Waschvorgang zu starten. Die Leuchtdioden 160, 162 der LED-Einheit 112 können zumindest teilweise dauerhaft eingeschaltet sein, um eine statische Hintergrundbeleuchtung für die berührungssensitive Einheit 106 zu realisieren.

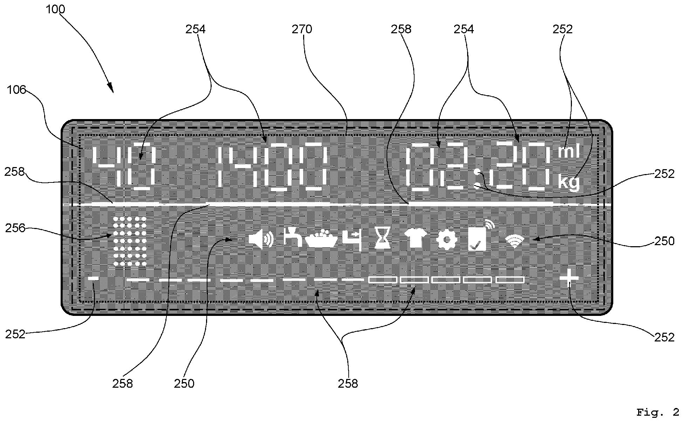

Die Figur 2 zeigt eine Draufsicht auf die Bedieneinheit von Figur 1 für ein Haushaltsgerät. Die Bedieneinheit 100 weist die hier verdeckte, berührungssensitive Einheit 106 von Figur 1 mit den Tastelektroden zur Aktivierung mittels einer Annäherung eines Fingers des Benutzers auf.

Die Bedieneinheit 100 verfügt über eine Vielzahl von Zeichen, wobei Zeichen 250 als Symbole bzw. als Piktogramme ausgebildet sind und weitere Zeichen 252 als Buchstaben bzw. Minuszeichen, Pluszeichen oder Punkte ausgestaltet sind. Weiterhin sind Zeichen 254 als 7-Segment-Ziffern zur Anzeige arabischer Zahlen ausgeführt und ein Zeichen 256 ist als eine 5 x 7 Punktmatrix zur Visualisierung von beliebigen alphanumerischen Zeichen wie lateinischen Buchstaben und arabischen Zahlen ausgebildet. Darüber hinaus ist eine Vielzahl von rechteckigen Zeichen 258 vorgesehen, die beispielsweise als eine Balkenanzeige, optische Trennelemente oder zur Abgabe von optischen Bedienerhinweisen dienen können.

Sämtliche Zeichen 250 bis 258 sind mittels Laserstrahlung innerhalb der Zeichenschicht der berührungssensitiven Einheit 106 beispielsweise durch Herausschneiden bzw. Heraustrennen, Lasergravur oder dergleichen ausgebildet und für das von den Leuchtdioden, den optionalen Leuchtdioden 7-Segment-Anzeigen oder den fakultativen Leuchtdioden 5 x 7 Punktmatrix-Anzeigen emittierte Licht durchlässig. Erforderlichenfalls kann die Zeichenschicht zumindest ergänzend auch aufgedruckte Zeichen aufweisen, was beispielsweise im Wege bekannter Siebdruckverfahren erfolgen kann.

Die berührungssensitive Einheit 106 kann gegebenenfalls zumindest bereichsweise als ein 2D-Sensor unter Schaffung eines berührungssensitiven Bereichs 270 ausgebildet sein. Hierdurch können die Zeichen 250 bis 258 praktisch frei, das heißt beliebig innerhalb der Zeichenschicht bzw. des berührungssensitiven Bereichs 270 unter Einsatz von Laserstrahlung ausgebildet werden. Der berührungssensitive 2D-Sensor kann beispielsweise mit einer Vielzahl von in einem Raster angeordneten, kapazitiven Tastelektroden der Funktionsschicht der berührungssensitiven Einheit 106 realisiert sein. Ein Raster, in dem die Tastelektroden der Funktionsschicht positioniert sind, ist bevorzugt orthogonal, gleichmäßig quadratisch sowie in Bezug auf die physische Größe der Zeichen hinreichend fein ausgeführt.

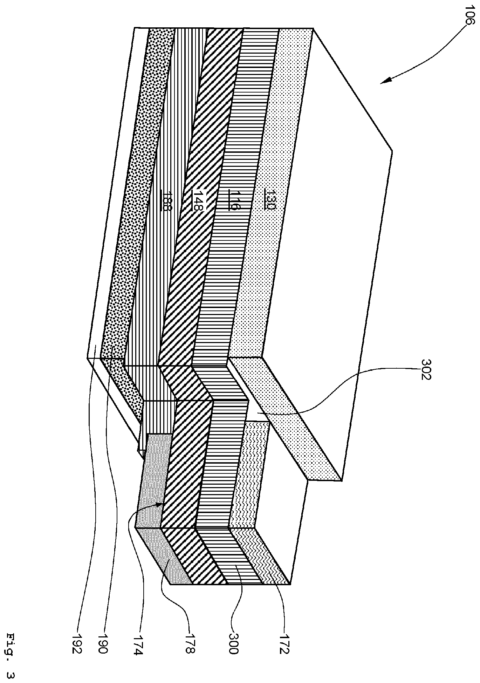

Die Figur 3 zeigt eine schematische, perspektivische Ansicht der berührungssensitiven Einheit der Bedieneinheit gemäß der Figuren 1, 2. Die berührungssensitive Einheit 106 umfasst die Diffusorfolie 116 mit der bedienerzugewandten Zeichenschicht 130 und der vom Bediener weggerichteten, das heißt nach unten orientierten Funktionsschicht 148. Die Funktionsschicht 148 ist unterseitig durch die Schutzschicht 188 vor schädlichen Umgebungseinflüssen, wie Korrosion, Feuchtigkeit und mechanischen Beeinträchtigungen geschützt. Unterhalb der Schutzschicht 188 verläuft zumindest bereichsweise die Klebeschicht 190, die ihrerseits zur Verbesserung der Handhabung während des Montageprozesses der Bedieneinheit mit der nicht haftenden, folienartigen Abziehschicht 192 versehen ist. Oberhalb eines Fortsatzes 300 der Diffusorfolie 116 ist die Zeichenschicht 130 weggelassen und die Versteifung 172 unter vorzugsweiser Schaffung eines Spalts 302 beabstandet zur Zeichenschicht 130 aufgebracht. Unterhalb des Fortsatzes 300 der Diffusorfolie 116 und hierbei im Wesentlichen deckungsgleich zu diesem verläuft die Funktionsschicht 148. An der Unterseite 174 der Funktionsschicht 148 ist das erste elektrische Interface 178 ausgebildet, das von der Schutzschicht 188 der Funktionsschicht 148 zumindest leicht überlappt wird.

Die Zeichenschicht 130 der Diffusorfolie 116 weist hier noch keine mittels Laserstrahlung eines geeigneten Lasers ausgebildete Zeichen auf.

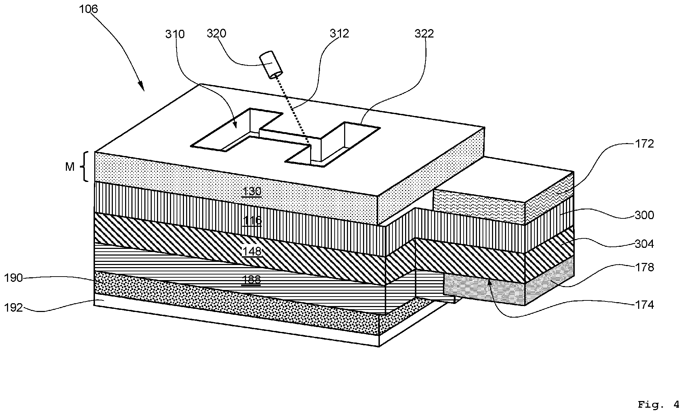

Die Figur 4 zeigt die berührungssensitive Einheit von Fig. 3 mit einem beispielhaften, mittels Laserstrahlung eines geeigneten Lasers ausgebildeten Zeichens. Der Schichtaufbau (so genannter "Stack") der berührungssensitiven Einheit 106 verfügt ausgehend von der bedienerzugewandten Zeichenschicht 130 über die Diffusorfolie 116, die Funktionsschicht 148, die Schutzschicht 188, die Klebeschicht 190 sowie die Abziehschicht 192. Oberhalb des Fortsatzes 300 der Diffusorfolie 116 ist die Versteifung 172 angeordnet. Unterhalb eines Fortsatzes 304 der Funktionsschicht 148 ist im Wesentlichen deckungsgleich zur Versteifung 172 das erste elektrische Interface 178 positioniert.

Im Unterschied zur Darstellung von Figur 3 ist in die Zeichenschicht 130 lediglich exemplarisch ein Zeichen 310, das den lateinischen Großbuchstaben "H" darstellt, mit Hilfe von Laserstrahlung 312 eines geeigneten Lasers 320 eingebracht. Das Zeichen 310 durchsetzt hier exemplarisch vollständig eine Materialstärke M der Zeichenschicht 130 und bildet somit eine für das Licht der hier nicht dargestellten LED-Einheit verlustfrei durchlässige Zeichenaussparung 322.

Aufgrund der Ausbildung der Zeichen der Zeichenschicht 130 mittels des Lasers 320 ist eine hohe grafische Variabilität der Zeichenschicht 130 gegeben, die sich leicht, flexibel und schnell an die Erfordernisse unterschiedlicher Typen und/oder Varianten von Haushaltsgeräten anpassen lässt. Hierbei gewährleistet der Einsatz der Laserstrahlung 312 eines nicht dargestellten Laserbeschriftungsgeräts eine äußerst konturscharfe, hochgradig maßhaltige und sicher reproduzierbare geometrische Gestaltung der einzelnen Zeichen. Die Intensität der Laserstrahlung 312 bzw. die Leistung des Lasers 320 ist hierbei so bemessen, dass beim Ausbilden der Zeichen in der Zeichenschicht 130 eine Beschädigung der darunter liegenden Diffusorfolie 116 ausgeschlossen ist.

Darüber hinaus lassen sich die Zeichen der Zeichenschicht 130 problemlos nach dem Abschluss der Montage der berührungssensitiven Einheit und der LED-Einheit zur Schaffung der Bedieneinheit - also unmittelbar vor deren Einbau in ein Haushaltsgerät - mittels des Lasers 320 herstellen.

Die Erfindung betrifft eine Bedieneinheit 100 für ein Haushaltsgerät mit einer berührungssensitiven Einheit 106 und einer rückseitig zu dieser positionierten LED-Einheit 112, wobei die berührungssensitive Einheit 106 mit einer Diffusorfolie 116 gebildet ist, deren einem Bediener zugewandte Oberseite 122 mindestens eine Zeichenschicht 130 und deren hiervon abgewandte Unterseite 142 mindestens eine Funktionsschicht 148 aufweist. Erfindungsgemäß ist vorgesehen, dass die mindestens eine Zeichenschicht 130 mindestens ein mittels Laserstrahlung 312 hergestelltes Zeichen 154, 156, 250, 252, 254, 256, 258 aufweist, das für Licht der LED-Einheit 112 zumindest teilweise durchlässig ist, wobei die Zeichenschicht 130 außerhalb des mindestens einen Zeichens 154, 156, 250, 252, 254, 256, 258 für Licht 164, 166 der LED-Einheit 112 undurchlässig ist. Hierdurch weist die Bedieneinheit 100 eine hohe Variabilität auf und lässt sich problemlos für unterschiedliche Typen und/oder Arten von Haushaltsgeräten mit einem geringen Aufwand anpassen.

### Bezugszeichenliste

- 100: Bedieneinheit
- 106: berührungssensitive Einheit
- 112: LED-Einheit
- 116: Diffusorfolie
- 122: Oberseite (Diffusorfolie)
- 124: Auge (menschlicher Bediener)
- 130: Zeichenschicht
- 142: Unterseite (Diffusorfolie)
- 148: Funktionsschicht
- 154: Zeichen
- 156: Zeichen
- 160: Leuchtdiode
- 162: Leuchtdiode
- 164: Licht
- 166: Licht
- 172: Versteifung
- 174: Unterseite (Funktionsschicht)
- 178: erstes elektrisches Interface
- 184: Abdeckung
- 188: Schutzschicht
- 190: Klebeschicht
- 192: Abziehschicht
- 194: Tastelektrode
- 196: Tastelektrode
- 200: elektronische Steuereinheit
- 206: Leiterplatte
- 210: zweites elektrisches Interface
- 216: Lichtschacht
- 218: Lichtschacht
- 220: Lichtführung
- 224: Blockierschicht
- 226: Oberseite (Lichtführung)

- 250: Zeichen (Symbol, Piktogramm)
- 252: Zeichen (Buchstaben)
- 254: Zeichen (7-Segment-Ziffer)
- 256: Zeichen (Punktmatrix)
- 258: Zeichen (Rechtecke)
- 270: berührungssensitiver Bereich (2D-Sensor)
- 300: Fortsatz (Diffusorfolie)
- 302: Spalt
- 304: Fortsatz (Funktionsschicht)
- 310: Zeichenaussparung
- 312: Laserstrahlung
- 320: Laser
- 322: Aussparung (Zeichen)

- A: Abstand
- M: Materialstärke (Zeichenschicht)

## Patentansprüche

1. Bedieneinheit (100) für ein Haushaltsgerät mit einer berührungssensitiven Einheit (106) und einer rückseitig zu dieser positionierten LED-Einheit (112), wobei die berührungssensitive Einheit (106) mit einer Diffusorfolie (116) gebildet ist, deren einem Bediener zugewandte Oberseite (122) mindestens eine Zeichenschicht (130) und deren hiervon abgewandte Unterseite (142) mindestens eine Funktionsschicht (148) aufweist, wobei die mindestens eine Funktionsschicht (148) eine Vielzahl von kapazitiven Tastelektroden (194, 196) aufweist, die dazu ausgebildet sind, im Fall einer räumlichen Annäherung eines Bedienerfingers jeweils ein auswertbares elektrisches Signal zu generieren, das mittels eines ersten elektrischen Interfaces (178) der mindestens einen Funktionsschicht (148) ableitbar ist,
wobei eine Leiterplatte (206) der LED-Einheit (112) mindestens eine Leuchtdiode (160, 162) zur bevorzugt selektiven Hinterleuchtung mindestens eines zugeordneten Zeichens (154, 156, 250, 252, 254, 256, 258) der Zeichenschicht (130) aufweist,
und wobei die Leiterplatte (206) der LED-Einheit (112) mindestens eine numerische und/oder alphanumerische Anzeige zur bevorzugt selektiven Hinterleuchtung eines zugeordneten Zeichens (154, 156, 250, 252, 254, 256, 258) der Zeichenschicht (130) aufweist,
wobei die mindestens eine Zeichenschicht (130) mindestens ein mittels Laserstrahlung (312) hergestelltes Zeichen (154, 156, 250, 252, 254, 256, 258) aufweist, das für Licht der LED-Einheit (112) zumindest teilweise durchlässig ist, wobei die Zeichenschicht (130) außerhalb des mindestens einen Zeichens (154, 156, 250, 252, 254, 256, 258) für Licht (164, 166) der LED-Einheit (112) undurchlässig ist,
wobei jeder Leuchtdiode (160, 162) und jeder numerischen oder alphanumerischen Anzeige der LED-Einheit (112) ein Lichtschacht (216, 218) als Teil einer Lichtführung (220) zugeordnet ist, und wobei die Lichtführung (220) außerhalb der Lichtschächte (216, 218) eine der berührungssensitiven Einheit (106) zugewandte lichtundurchlässige Blockierschicht (224) aufweist,
**dadurch gekennzeichnet, dass** die mindestens eine Funktionsschicht (148) unterseitig mit einer Schutzschicht (188) versehen ist, die ihrerseits unterseitig zumindest bereichsweise mit einer Klebeschicht (190) versehen ist, wobei die Klebeschicht (190) unterseitig eine nicht adhäsive Abziehschicht (192) aufweist.

2. Bedieneinheit (100) nach Patentanspruch 1, **dadurch gekennzeichnet, dass** die Leiterplatte (206) der LED-Einheit (112) ein zweites elektrisches Interface (210) aufweist, das mit dem ersten elektrischen Interface (178) der berührungssensitiven Einheit (106) und/oder mit mindestens einer der Leiterplatte (206) zugeordneten elektronischen Steuereinheit (200) und/oder einer elektronischen Steuer- und/oder Regeleinheit des Haushaltsgeräts verbunden ist.

3. Bedieneinheit (100) nach Patentanspruch 1, **dadurch gekennzeichnet, dass** die elektronische Steuereinheit (200) zumindest dazu ausgebildet ist, die elektrischen Signale der kapazitiven Tastelektroden (194, 196) auszuwerten.

4. Bedieneinheit (100) nach einem der Patentansprüche 1 bis 3, **dadurch gekennzeichnet, dass** die Zeichenschicht (130) eine lichtdurchlässige Abdeckung (184) aufweist.

5. Bedieneinheit (100) nach Patentanspruch 1, **dadurch gekennzeichnet, dass** die berührungssensitive Einheit (106) einen 2D-Sensor unter Schaffung eines berührungssensitiven Bereichs (270) aufweist, derart, dass das mindestens eine Zeichen (154, 156, 250, 252, 254, 256, 258) der Zeichenschicht (130) weitgehend frei innerhalb des berührungssensitiven Bereichs (270) ausbildbar ist.

## Claims

1. Operating unit (100) for a household appliance having a touch-sensitive unit (106) and an LED unit (112) positioned to the rear of the same, wherein the touch-sensitive unit (106) is formed with a diffusor film (116), the top side (122) of which facing an operator has at least one layer of symbols (130) and the bottom side (142) of which facing away herefrom has at least one functional layer (148), wherein the at least one functional layer (148) has a plurality of capacitive working electrodes (194, 196), which are embodied in each case to generate an evaluable electrical signal if a finger of an operator were to approach spatially, said electrical signal being derivable by means of a first electrical interface (178) of the at least one functional layer (148),
wherein a conductor board (206) of the LED unit (112) has at least one light-emitting diode (160, 162) for the preferably selective backlighting of at least one assigned symbol (154, 156, 250, 252, 254, 256, 258) of the layer of symbols (130),
and wherein the conductor board (206) of the LED unit (112) has at least one numerical and/or alphanumerical display for the preferably selective backlighting of an assigned symbol (154, 156, 250, 252, 254, 256, 258) of the layer of symbols (130),
wherein the at least one layer of symbols (130) has at least one symbol (154, 156, 250, 252, 254, 256, 258) which is produced by means of laser radiation (312) and is at least partially permeable to light from the LED unit (112), wherein the layer of symbols (130) outside of the at least one symbol (154, 156, 250, 252, 254, 256, 258) is impermeable to light (164, 166) of the LED unit (112),
wherein each light-emitting diode (160, 162) and each numerical or alphanumerical display of the LED unit (112) is assigned a funnel (216, 218) as part of a light guide (220), and wherein the light guide (220) outside of the funnels (216, 218) has a light-impermeable blocking layer (224) facing the touch-sensitive unit (106),
**characterised in that** the at least one functional layer (148) is provided on the underside with a protective layer (188) which is provided for its part at least in sections on the underside with an adhesive layer (190), wherein the adhesive layer (190) has a non-adhesive peel coat (192) on the underside.

2. Operating unit (100) according to claim 1, **characterised in that** the conductor board (206) of the LED unit (112) has a second electrical interface (210), which is connected to the first electrical interface (178) of the touch-sensitive unit (106) and/or with at least one electronic control unit (200) assigned to the conductor board (206) and/or an electronic control and/or regulating unit of the household appliance.

3. Operating unit (100) according to claim 1, **characterised in that** the electronic control unit (200) is at least embodied to evaluate the electrical signals of the capacitive working electrodes (194, 196).

4. Operating unit (100) according to one of claims 1 to 3, **characterised in that** the layer of symbols (130) has a light-permeable cover (184).

5. Operating unit (100) according to claim 1, **characterised in that** the touch-sensitive unit (106) has a 2D sensor by creating a touch-sensitive region (270), such that the at least one symbol (154, 156, 250, 252, 254, 256, 258) of the layer of symbols (130) can be formed largely freely within the touch-sensitive region (270).

## Revendications

1. Panneau de commande (100) pour un appareil électroménager comprenant une unité tactile (106) et une unité LED (112) positionnée à l'arrière de celle-ci, dans lequel l'unité tactile (106) est fabriquée avec un film diffusant (116), dont la face supérieure (122) orientée vers un utilisateur comprend au moins une couche de caractères (130) et dont la face inférieure (142) opposée à celle-ci comprend au moins une couche fonctionnelle (148),
dans lequel l'au moins une couche fonctionnelle (148) comprend une pluralité d'électrodes de détection tactile capacitives (194, 196) qui sont configurées pour générer respectivement un signal électrique exploitable lorsqu'un doigt d'utilisateur s'approche, qui peut être transmis au moyen d'une première interface électrique (178) de l'au moins une couche fonctionnelle (148),
dans lequel une plaque de circuit imprimé (206) de l'unité LED (112) comprend au moins une diode électroluminescente (160, 162) assurant un rétroéclairage de préférence sélectif d'au moins un caractère associé (154, 156, 250, 252, 254, 256, 258) de la couche de caractères (130),
et dans lequel la plaque de circuit imprimé (206) de l'unité LED (112) comprend au moins un élément d'affichage numérique et/ou alphanumérique pour le rétroéclairage de préférence sélectif d'un caractère associé (154, 156, 250, 252, 254, 256, 258) de la couche de caractères (130),
dans lequel l'au moins une couche de caractères (130) comprend au moins un caractère (154, 156, 250, 252, 254, 256, 258) fabriqué au moyen d'un rayonnement laser (312), lequel caractère est transparent au moins en partie à la lumière émise par l'unité LED (112),
dans lequel la couche de caractères (130) à l'extérieur de l'au moins un caractère (154, 156, 250, 252, 254, 256, 258) est opaque à la lumière (164, 166) de l'unité LED (112),
dans lequel un puits de lumière (216, 218) sous forme de partie d'un guide de lumière (220) est associé à chaque diode électroluminescente (160, 162) et à chaque élément d'affichage numérique ou alphanumérique de l'unité LED (112), et
dans lequel le guide de lumière (220) comprend à l'extérieur des puits de lumière (216, 218) une couche de blocage opaque (224) orientée vers l'unité tactile (106), **caractérisé en ce que** l'au moins une couche fonctionnelle (148) est pourvue sur le dessous d'une couche de protection (188), qui est pourvue à son tour sur le dessous d'une couche de colle (190) au moins par endroits, dans lequel la couche de colle (190) comprend sur le dessous une couche de séparation non adhésive (192).

2. Panneau de commande (100) selon la revendication 1, **caractérisé en ce que** la plaque de circuit imprimé (206) de l'unité LED (112) comprend une deuxième interface électrique (210), qui est reliée à la première interface électrique (178) de l'unité tactile (106) et/ou à au moins une unité de commande électronique (200) associée à la plaque de circuit imprimé (206) et/ou à une unité de commande et/ou de régulation électronique de l'appareil électroménager.

3. Panneau de commande (100) selon la revendication 1, **caractérisé en ce que** l'unité de commande électronique (200) est conçue au moins pour exploiter les signaux électriques des électrodes de détection tactile capacitives (194, 196).

4. Panneau de commande (100) selon l'une des revendications 1 à 3, **caractérisé en ce que** la couche de caractères (130) comprend un revêtement transparent à la lumière (184).

5. Panneau de commande (100) selon la revendication 1, **caractérisé en ce que** l'unité tactile (106) comprend un capteur 2D permettant de créer une zone tactile (270), de telle sorte qu'au moins un caractère (154, 156, 250, 252, 254, 256, 258) de la couche de caractères (130) soit configurable à une position choisie essentiellement librement dans la zone tactile (270).
